# EUROPEAN PATENT SPECIFICATION

(11) **EP 3 160 041 B1**
(45) Date of publication and mention of the grant of the patent: **26.12.2018**
(21) Application number: 16151170.4
(22) Date of filing: 14.01.2016
(51) Int. Cl.: H02S 40/36, H02S 40/34, H01L 31/05, H01L 31/02

(54) **SOLAR PANEL MODULE AND SOLAR PANEL APPARATUS**
SOLARPANEELMODUL UND SOLARPANEELVORRICHTUNG
MODULE DE PANNEAU SOLAIRE ET APPAREIL À PANNEAU SOLAIRE

(30) Priority: 22.10.2015 TW 104134753
(43) Date of publication of application: 26.04.2017
(73) Proprietor: Eterbright Solar Corporation, Toufen City, Miaoli County (TW)
(72) Inventor: HUANG, TING-HUI, 35154 Miaoli County (TW)
(74) Representative: Straus, Alexander

(56) References cited:
- CN-U- 202 231 043
- CN-U- 202 549 853
- DE-A1-102013 211 179
- JP-A- 2006 032 501
- US-A1- 2012 312 347
- SHEPARD N F ET AL: "THE INTEGRATION OF BYPASS DIODES WITH TERRESTRIAL PHOTOVOLTAIC MODULES AND ARRAYS", PHOTOVOLTAIC SPECIALISTS CONFERENCE. KISSIMMEE, MAY 1 - 4, 1984; [PHOTOVOLTAIC SPECIALISTS CONFERENCE], NEW YORK, IEEE, US, vol. CONF. 17, no. 1984, 1 May 1984 (1984-05-01), pages 676-681, XP000013439,

## Description

### FIELD OF THE DISCLOSURE

The present invention is related to a solar panel module and an solar panel apparatus.

### BACKGROUND OF THE INVENTION

Generally, in order to generate more power, a solar panel apparatus capable of generating enough power requires multiple solar panels. Because different customers may have different requirements, it is difficult to satisfy different customers with solar panel apparatus of single spec.

Therefore, the industry needs an easily customized and easily assembled solar panel apparatus to address this problem. Documents CN 202549853 U and DE 102013 211 179 A1 disclose solar panel modules as known in the prior art.

### SUMMARY OF THE INVENTION

The subject matter of the present invention is defined in claim 1. One purpose of the present invention is to provide a solar panel apparatus comprising a first solar panel module. The first solar panel module comprises a first front surface configured to subject to sun light and a first back surface configured to be away from the sun light, at least a first solar panel having a plurality of first solar cell units electrically connected with each other, and a first anode and a first cathode. The first solar panel module further comprises a first anode junction box and a first cathode junction box, a first anode auxiliary junction box and a first cathode auxiliary junction box, and a first anode cable and a first cathode cable. The first anode junction box and the first cathode junction box are disposed along one short edge of the first back surface and are electrically connected to the first anode and the first cathode respectively. The first anode auxiliary junction box and the first cathode auxiliary junction box are disposed along the other short edge of the first back surface opposite to the one short edge. The first anode junction box and the first anode auxiliary junction box are electrically connected through the first anode cable. The first cathode junction box and the first cathode auxiliary junction box are electrically connected through the first cathode cable. No bypass diodes are disposed in any one of the first anode junction box, the first cathode junction box, the first anode auxiliary junction box and the first cathode auxiliary junction box.

According to one embodiment of the present invention, the plurality of first solar cell units are electrically connected in serial.

According to one embodiment of the present invention, the solar panel apparatus further comprises a first three-way connector and a second three-way connector, and an anode external connecting cable and a cathode external connecting cable. The anode external connecting cable electrically connects the first anode junction box and a first terminal of the first three-way connector. The cathode external connecting cable electrically connects the first cathode junction box and a first terminal of the second three-way connector.

According to one embodiment of the present invention, the solar panel apparatus further comprises a bypass diode electrically coupling a second terminal of the first three-way connector and a second terminal of the second three-way connector.

According to one embodiment of the present invention, the solar panel apparatus further comprises a first anode internal connecting cable and a first cathode internal connecting cable. The first anode internal connecting cable electrically connects the first anode auxiliary junction box and a second anode of a second solar module. The first cathode internal connecting cable electrically connects the first cathode auxiliary junction box and a second cathode of the second solar module.

According to one embodiment of the present invention, the solar panel apparatus further comprises a n^{th} solar panel module. The n^{th} solar panel module comprises a n^{th} front surface configured to subject to sun light and a n^{th} back surface configured to be away from sun light, at least one n^{th} solar panel having a plurality of n^{th} solar cell units electrically connected with each other, and a n^{th} anode and a n^{th} cathode. The n^{th} solar panel module further comprises a n^{th} anode junction box and a n^{th} cathode junction box disposed along one short edge of the n^{th} back surface and electrically connected to a n^{th} anode and a n^{th} cathode respectively, a n^{th} anode auxiliary junction box and a n^{th} cathode auxiliary junction box disposed along the other short edge of the n^{th} back surface opposite to the one short edge, a n^{th} anode cable electrically connecting the n^{th} anode junction box and the n^{th} anode auxiliary junction box, and a n^{th} cathode cable electrically connecting the n^{th} cathode junction box and the n^{th} cathode auxiliary junction box. The solar panel apparatus further comprises a n^{th} anode internal connecting cable and a n^{th} cathode internal connecting cable. The n^{th} anode internal connecting cable electrically connects the n^{th} anode auxiliary junction box and a (n+1)^{th} anode of a (n+1)^{th} solar panel module. The n^{th} cathode internal connecting cable electrically connects the n^{th} cathode auxiliary junction box and a (n+1)^{th} cathode of the (n+1)^{th} solar panel module. N is an integer equivalent to or greater than 2.

According to one embodiment of the present invention, the solar panel apparatus further comprises a (n+1)^{th} solar panel module. The (n+1)^{th} solar panel module comprises a (n+1)^{th} front surface configured to subject to sun light and a (n+1)^{th} back surface configured to be away from sun light, at least one (n+1)^{th} solar panel having a plurality of (n+1)^{th} solar cell units electrically connected with each other, and the (n+1)^{th} anode and the (n+1)^{th} cathode. The (n+1)^{th} solar panel module further comprises a (n+1)^{th} anode junction box and a (n+1)^{th} cathode junction box disposed along one short edge of the (n+1)^{th} back surface and electrically connected to the (n+1)^{th} anode and the (n+1)^{th} cathode respectively.

According to one embodiment of the present invention, there are no bypass diodes disposed in all junction boxes of the n^{th} and (n+1)^{th} solar panel modules.

According to one embodiment of the present invention, the (n+1)^{th} solar panel module comprises no junction boxes other than the (n+1)^{th} anode junction box and the (n+1)^{th} cathode junction box.

According to one embodiment of the present invention, the first solar panel module through the (n+1)^{th} solar panel module are electrically connected in parallel.

The solar panel modules of the solar panel apparatus of the present invention are divided into the first, intermediate and the last solar panel modules, and are standardized accordingly. By adjusting numbers of the intermediate solar panel modules, it is possible to rapidly assemble a customized solar panel apparatus required by a customer.

### BRIEF DESCRIPTION OF THE DRAWINGS

FIG. 1 shows a solar panel according to one embodiment of the present invention.
FIG. 2 shows a top view of a back surface of a solar panel module according to one embodiment of the present invention.
FIG. 3 shows a top view of a back surface of a solar panel module according to another embodiment of the present invention.
FIG. 4 shows a solar panel apparatus according to one embodiment of the present invention.

### DESCRIPTION OF THE PREFERRED EMBODIMENTS

The following descriptions illustrate preferred embodiments of the present invention in detail. All the components, sub-portions, structures, materials and arrangements therein can be arbitrarily combined in any sequence despite their belonging to different embodiments and having different sequence originally. All these combinations are falling into the scope of the present invention.

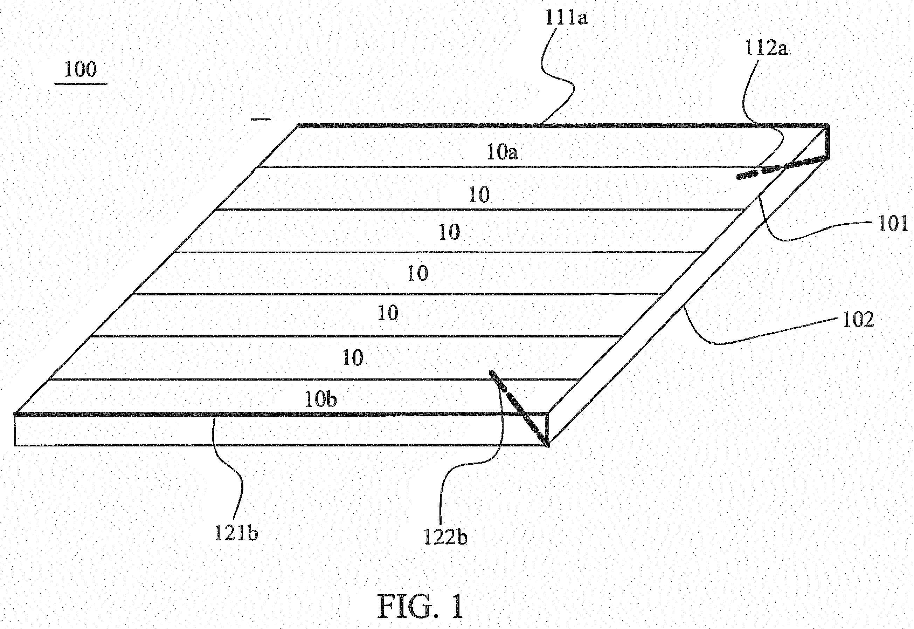

There are a lot of embodiments and figures within this application. To avoid confusions, similar components are designated by the same or similar numbers. To simplify figures, repetitive components are only marked once. FIG.1 shows a solar panel 100 according to one embodiment of the present invention. The solar panel 100 comprises a front surface 101 configured to subject to sun light and a back surface 102 configured to be away from sun light. The solar panel 100 comprises a plurality of solar cell units 10a, 10b and 10 electrically connected in serial. Solar cell units 10a and 10b represent solar cell units at two ends of the solar panel 100 while solar cell unit 10 represents one of the solar cell units between the solar cell units 10a and 10b. The solar panel 100 preferably has a rectangle shape with two long edges and two short edges. A front surface anode ribbon 121b and a front surface cathode ribbon 111a are disposed at two long sides opposite to each other of the front surface 101 of the solar panel 100 and are folded to the back surface 102 of solar panel 100 to become a back surface anode ribbon 122b and a back surface cathode ribbon 112a respectively. In most of the figures of the present invention, the back surface anode ribbon 122b and the back surface cathode ribbon 112a are shown by dashed lines to be different from the front surface anode ribbon 121b and the front surface cathode ribbon 111a shown by solid lines. The front surface anode ribbon 121b and the front surface cathode ribbon 111a are used as an anode electrode and a cathode electrode of the solar panel 100 respectively. The front surface anode ribbon 121b and the front surface cathode ribbon 111a may be folded to the back surface 102 from the same short edge of the solar panel 100 as shown in FIG. 1 or folded to the back surface 102 from different short edges of the solar panel 100 (not shown). The ribbons for example can be made from copper foil, copper ribbon, foils of other metals or alloy or ribbons of other metals or alloys.

Although not shown in FIG. 1, each solar panel of the present invention such as the solar panel 100 has a stacked structure from bottom to top comprising a back glass, a patterned lower electrode layer, a patterned photoelectric conversion layer, an optional patterned buffer layer and a patterned transparent upper electrode layer. The patterned lower electrode layer and the patterned transparent upper electrode layer are configured to conduct electrical current generated by the patterned photoelectric conversion layer. The patterned photoelectric conversion layer is configured to receive light penetrating the patterned transparent upper electrode layer and the optional patterned buffer layer and to convert the light into electricity. The photoelectric conversion layer may be formed from a semiconductor material composed of copper (Cu), indium (In), gallium (Ga) and selenium (Se). Alternatively, the photoelectric conversion layer may be formed from a semiconductor compound material comprising Ib group element such as copper (Cu) or silver (Ag), IIIb group element such as aluminum (Al), gallium (Ga) or indium (In) and VIb group element such as sulfur (S), selenium (Se) or tellurium (Te). The transparent upper electrode layer may use indium tin oxide (ITO) and/or zinc oxide (ZnO). The lower electrode layer may use molybdenum (Mo).

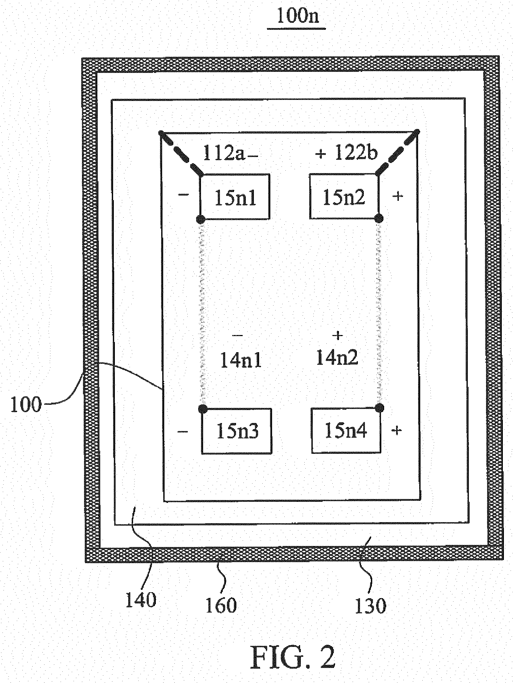

Now please refer to FIG. 2. FIG. 2 shows a top view of the back surface of a solar panel module 100n according to one embodiment of the present invention. The solar panel module 100n comprises only one solar panel 100, a back sheet 130 with a size slightly larger than a size of the solar panel 100 disposed on the back surface 102 of the solar panel 100, a cover panel 140 with a size equivalent to or slightly smaller than the size of the back sheet 130 disposed on the front surface 101 of the solar panel 100, and a frame 160 configured to engage with a periphery region of the back sheet 130 and a periphery region of the cover panel 140. The cover panel 140 for example is a rigid glass panel. The back sheet 130 for example is a rigid back sheet or a flexible back sheet. Rigid back sheet may be a tempered glass, a chemically strengthened glass or a polymeric resin sheet. Flexible back sheet may be a high-tensile plastic sheet such as polyethylene (PE) sheet, polyamide (PA) sheet, polyethylene terephthalate (PET) sheet or a combination thereof. The back sheet 130 may also be a combination of a material listed above and a metallic foil attached thereto. The frame 160 may be composed of several sub-portions attached to the cover panel 140 and/or the back sheet 130 by adhesives or sealants. Additionally, the solar panel module 100n further comprises the back surface anode ribbon 122b and the back surface cathode ribbon 112a formed by folding the front surface anode ribbon and the front surface cathode ribbon to the back surface 102 respectively, an anode cable 14n2 and a cathode cable 14n1, an anode junction box 15n2 and a cathode junction box 15n1, and an anode auxiliary junction box 15n4 and a cathode auxiliary junction box 15n3. The cathode junction box15n1 and the anode junction box 15n2 are disposed along one short edge of the back surface 102 of the solar panel 100 to electrically connect to the back surface cathode ribbon 112a and the back surface anode ribbon 122b respectively. The cathode auxiliary junction box 15n3 and the anode auxiliary junction box 15n4 are disposed along the other short edge of the back surface 102 of the solar panel 100 to electrically connect to the cathode junction box 15n1 and the anode junction box 15n2 respectively by the cathode cable 14n1 and the anode cable 14n2. The cathode junction box 15n1 and the anode junction box 15n2 may be connected to an external device such as an electricity storage device or consumer electronics while the cathode auxiliary junction box 15n3 and the anode auxiliary junction box 15n4 may be connected to the next solar panel module.

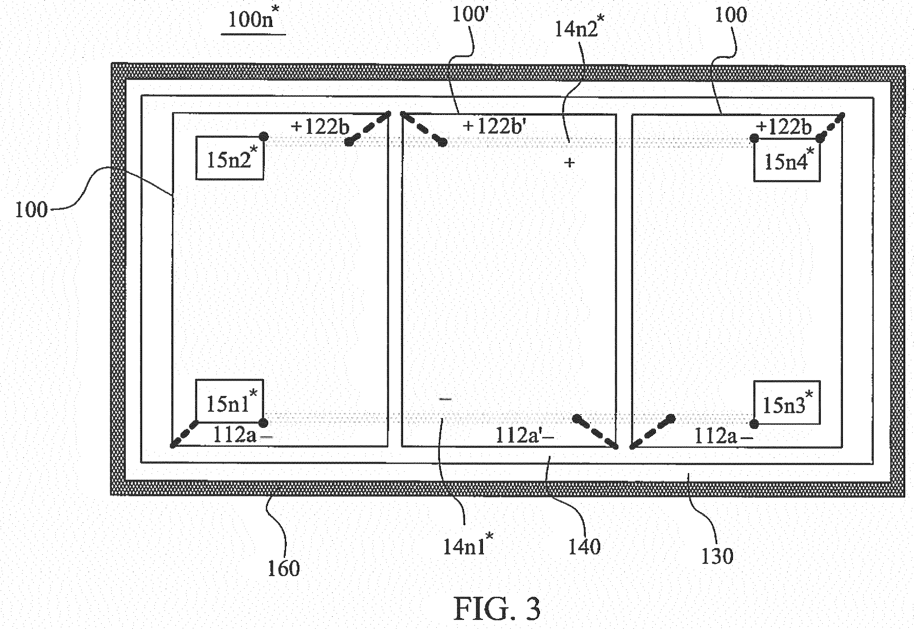

FIG. 3 shows a top view of the back surface of a solar panel module 100n* according to another embodiment of the present invention. The solar panel 100n* comprises three solar panels (100, 100' and 100), a back sheet 130 with a size slightly larger than a size of one solar panel of the solar panels disposed on the back surface 102 of the solar panel, a cover panel 140 with a size equivalent to or slightly smaller than the size of the back sheet 130 disposed on the front surface 101 of the solar panel, and a frame 160 configured to engage with a periphery region of the cover panel 140 and/or a periphery region of the back sheet 130. The solar panels 100 and 100' are substantially the same in view of their structures except the relative positions of ribbons. The cover panel 140, the back sheet 130, and the frame 160 are similar to the ones disclosed in FIG. 2 and their details are omitted here. Additionally, the solar panel module 100n* further comprises the back surface anode ribbon 122b and the back surface cathode ribbon 112a formed by folding the front surface anode ribbon and the front surface cathode ribbon to the back surface of the solar panel 100 respectively, the back surface anode ribbon 122b' and the back surface cathode ribbon 112a' formed by folding the front surface anode ribbon and the front surface cathode ribbon to the back surface of the solar panel 100' respectively, an anode cable 14n2* and a cathode cable 14n1*, an anode junction box 15n2* and a cathode junction box 15n1*, and an anode auxiliary junction box 15n4* and a cathode auxiliary junction box 15n3*. The anode junction box 15n2* and the cathode junction box 15n1* are disposed at the first (most left) solar panel 100 while the anode auxiliary junction box 15n4* and the cathode auxiliary junction box15n3* are disposed at the last (most right) solar panel 100. The anode cable 14n2* and the cathode cable 14n1* are disposed between the anode junction box 15n2* and the cathode junction box 15n1* and the anode auxiliary junction box 15n4* and the cathode auxiliary junction box 15n3* across all the solar panels 100 and 100'. The anode cable 14n2* electrically connects the anode junction box 15n2*, all the back surface anode ribbons 122b/122b' of all the solar panels 100/100', and the anode auxiliary junction box 15n4*. The cathode connecting ribbon 125n* electrically connects the cathode junction box 15n1*, all the back surface cathode ribbons 112a/112a' of all the solar panels 100/100', and the cathode auxiliary junction box 15n3*. Similarly, one of the cathode junction box 15n1* and the anode junction box 15n2* may be electrically connected to an external device such as an electricity storage device or consumer electronics while the other one of the cathode junction box 15n1* and the anode junction box 15n2* may be electrically connected to the next solar panel module.

Although in the embodiment of FIG. 3 the solar panel module comprises only three solar panels, a person skilled in the art should understand it is possible for a solar panel module of the present invention to comprise more than three solar panels, a cathode junction box and an anode junction box, a cathode auxiliary junction box and an anode auxiliary junction box, and a cathode cable and an anode cable connecting the junction boxes and the auxiliary junction boxes. Although in the embodiments of FIGS. 2 and 3 the junction boxes are disposed at the back surfaces of the solar panels, it is possible to dispose the junction boxes at sidewalls or front surfaces of the solar panels.

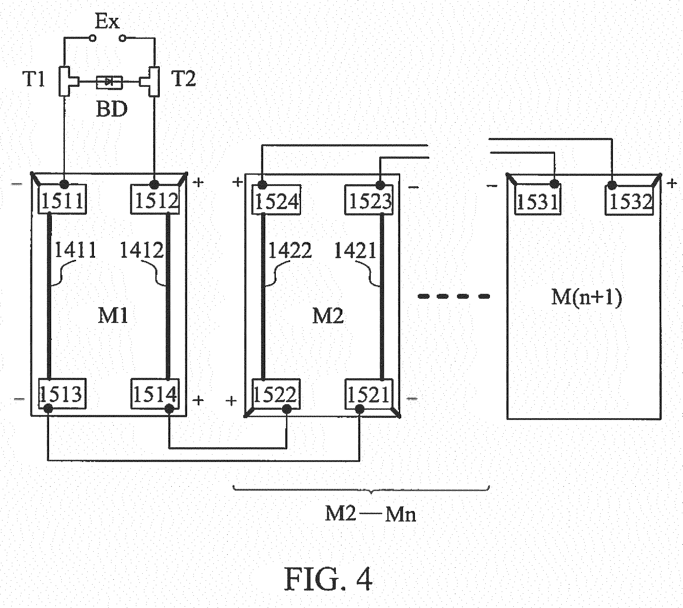

Now please refer to FIG. 4. FIG. 4 shows a solar panel apparatus 1000 according to one embodiment of the present invention. The solar panel apparatus 1000 comprises at least two solar panel modules electrically connected for example the solar panel modules 100n shown in FIG. 2 or the solar panel modules 100n* shown in FIG. 3: a first solar panel module M1, optionally disposed intermediate solar panel modules M2-Mn, and a last solar panel module M(n+1), wherein n is an integer. As shown in FIG. 1, each solar panel included in the first solar panel module, intermediate solar panel modules, and the last solar panel module preferably comprises a front surface configured to subject to sun light and a back surface configured to be away from sun light, a plurality of solar cell units especially a plurality of solar cell units electrically connected in serial, and an anode and a cathode. When n is equivalent to 1, the solar panel apparatus 1000 only comprises the first solar panel module M1 and the last solar panel module M2. When n is greater than 1 for example 2, 3, 4, and more, the solar panel apparatus 1000 comprises not only the first solar panel module M1 and the last solar panel module M(n+1) but also at least one intermediate solar panel module Mn. Regardless of n, the first solar panel module M1 remains the same in view of its structure and components. Similarly, regardless of n, the last solar panel module M(n+1) remains the same in view of its structure and components. When n is greater than 1, regardless of n, each intermediate solar panel module M2-Mn are the same in view of their structure and components. Therefore, if a solar panel apparatus comprising 8 solar panel modules is required, one may assemble a first solar panel module M1, 6 intermediate solar panel modules M2-M7, and a last solar panel module M8 together to complete the solar panel apparatus required. Moreover, solar panel modules may be pre-assembled with its related components to become a sub-apparatus to further enhance throughput. To this end, the first solar panel module M1 and the intermediate solar panel modules M2-Mn are the same and they may be the solar panel modules shown in FIG. 2 or FIG. 3. The first solar panel module and the intermediate solar panel modules are classified into different categories because the first solar panel module is connected to external device while the intermediate solar panel modules are not.

The first solar panel module M1 of the solar panel apparatus 1000 comprises a first anode junction box 1512 and a first cathode junction box 1511 disposed along one short edge of a first back surface a first anode auxiliary junction box 1514 and a first cathode auxiliary junction box 1513 disposed along the other short edge of the first back surface, a first anode cable 1412 electrically connecting the first anode junction box 1512 and the first anode auxiliary junction box 1514, and a first cathode cable 1411 electrically connecting the first cathode junction box 1511 and the first cathode auxiliary junction box 1513. The first anode cable 1412 and the first cathode cable 1411 for example are buses. The first anode junction box 1512 and the first cathode junction box 1511 are electrically connected to a first anode and a first cathode (not shown) of the first solar panel module M1. There are no bypass diodes in the first anode junction box 1512, the first cathode junction box 1511, the first anode auxiliary junction box 1514, and the first cathode auxiliary junction box 1513. The solar panel apparatus 1000 at the first solar panel module M1 further comprises a first anode internal connecting cable and a first cathode internal connecting cable (not numbered) for electrically connecting the first solar panel module M1 and the next solar panel module M2. More specifically, the first anode internal connecting cable electrically connects the first anode auxiliary junction box 1514 of the first solar panel module M1 to a second anode of the second solar panel module M2 for example through a second anode junction box 1522 of the second solar panel module M2; the first cathode internal connecting cable electrically connects the first cathode auxiliary junction box 1513 and a second cathode of the second solar panel module M2 for example through a second cathode junction box 1521. It is noted that although in FIG. 4 the first anode internal connecting cable and first cathode internal connecting cable are drawn as single lines, each internal connecting cable may comprise two or more connecting cables or wires. For example, one internal connecting cable may comprise a male-ended connecting cable from the first anode auxiliary junction box 1514 of the first solar panel module M1 and a female ended connecting cable from the first anode junction box 1522 of the second solar panel module M2, wherein the male-ended connecting cable is connected to the female-ended connecting cable.

In a case where the solar panel apparatus 1000 comprises one or more solar panel modules of the intermediate solar panel modules M2-Mn, all the intermediate solar panel modules M2-Mn are the same. Therefore, the intermediate solar panel modules M2-Mn are explained taking example of M2. The intermediate solar panel module M2 of the solar panel apparatus 1000 comprises a second anode junction box 1522 (15n2) and a second cathode junction box 1521 (15n1) disposed along one short edge of a second back surface, a second anode auxiliary junction box 1524 (15n4) and a second cathode auxiliary junction box 1523 (15n3) disposed along the other short edge of the second back surface, a second anode cable 1422 (14n2) electrically connecting the second anode junction box 1522 (15n2) and the second anode auxiliary junction box 1524 (15n4), and a second cathode cable 1421 (14n1) electrically connecting the second cathode junction box 1521 (15n1) and the second cathode auxiliary junction box 1523 (15n3). The second anode cable 1422 (14n2) and the second cathode cable 1421 (14nl) for example are buses. The second anode junction box 1522 (15n2) and the second cathode junction box 1521 (15n1) are electrically connected to a second anode (n^{th} anode) and a second cathode (n^{th} cathode) of the second solar panel module M2 (Mn). The solar panel apparatus 1000 at the intermediate solar panel module M2 (Mn) further comprises a second anode internal connecting cable (n^{th} anode internal connecting cable) and a second cathode internal connecting cable (n^{th} cathode internal connecting cable) for electrically connecting the second solar panel module M2 (Mn) and the next solar panel module M3 (Mn+1). More specifically, the second anode internal connecting cable (n^{th} anode internal connecting cable) electrically connects the second anode auxiliary junction box 1524 (15n4) of the second solar panel module M1 (Mn) to a third anode ((n+1)^{th} anode) of the third solar panel module M3 (Mn+1) for example through a third anode junction box 1532 (15(n+1)2) of the third solar panel module M3 (Mn+1); the second cathode internal connecting cable (n^{th} cathode internal connecting cable) electrically connects the second cathode auxiliary junction box 1523 (15n3) and a third cathode ((n+1)^{th} cathode) of the third solar panel module M3 (M(n+1)) for example through a third cathode junction box 1531 (15(n+1)1) of the third solar panel module M3 (Mn+1). The second anode internal connecting cable and the second cathode internal connecting cable are similar to the first anode internal connecting cable and the first cathode internal connecting cable that they may comprise two or more male-ended and female-ended cables or wires.

The solar panel apparatus 1000 further comprises the last solar panel module M(n+1). Here the last solar panel module M(n+1) is explained taking example of n equivalent to 2. The last solar panel module M3 (M(n+1)) of the solar panel apparatus 1000 comprises a third anode junction box 1532 (15(n+1)2) and a third cathode junction box 1531 (15(n+1)1) disposed along one short edge of a third back surface. The third anode junction box 1532 (15(n+1)2) and the third cathode junction box 1531 (15(n+1)1) are electrically connected to a third anode ((n+1)^{th} anode) and a third cathode ((n+1)^{th} cathode) of the third solar panel module M3 (M(n+1)). There are no other junction boxes disposed at the third solar panel module M3 (Mn+1) except the third anode junction box 1532 (15(n+1)2) and the third cathode junction box 1531 (15(n+1)1).

To reinforce the liability of the solar panel apparatus, the solar panel apparatus 1000 may optionally comprise a first three-way connector T1, a second three-way connector T2, an anode external connecting cable (not numbered) electrically connecting the first anode junction box 1512 of the first solar panel module M1 and a first terminal of the first three-way connector T1, a cathode external connecting cable (not numbered) electrically connecting the first cathode junction box 1511 of the first solar panel module M1 and a first terminal of the second three-way connector T2, and a bypass diode BD electrically coupling such as directly contacting a second terminal of the first three-way connector T1 and a second terminal of the second three-way connector T2. A third terminal of the first three-way connector T1 and a third terminal of the second three-way connector T2 are for example electrically connected to an external device such as an electricity storage device or consumer electronics. The anode external connecting cable and the cathode external connecting cable are similar to first anode internal connecting cable and the first cathode internal connecting cable that they may comprise two or more male-ended and female-ended cables or wires. The bypass diode BD may be directly connected to terminals of the first and second three-way connectors or optionally disposed in a junction box. The bypass diode BD is configured to avoid solar panels (solar panel cell units within any solar panels) from overheating or even breaking down due to non-uniform sun light. Except for the bypass diode BD disposed outside the first solar panel module, other bypass diodes may be optionally disposed in any junction boxes in some of or all the intermediate solar panel modules.

In the embodiment of FIG. 4, the first solar panel module, the intermediate solar panel modules, and the last solar panel module are electrically connected in parallel. However, it is noted that the present invention may be applied to a case where all the solar panel modules are electrically connected in serial. To adapt serial connections, the components of each solar panel module (various junction boxes and connecting cables) and/or orientation of these components (relative locations of these components within a solar panel module) may change accordingly. Furthermore, all the cables and wires capable of electrically connections in the present invention are not limited to specific spec or structure. For example, they may be water-resistant connecting cables complying with MC4 spec.

While the invention has been described in terms of what is presently considered to be the most practical and preferred embodiments, it is to be understood that the invention needs not be limited to the disclosed embodiment. On the contrary, it is intended to cover various modifications and similar arrangements included within the scope of the appended claims which are to be accorded with the broadest interpretation so as to encompass all such modifications and similar structures.

## Claims

1. A solar panel apparatus (1000) comprising:
first solar panel module (M1) comprising a first front surface (101) configured to subject to sun light and a first back surface (102) configured to be away from sun light, at least one first solar panel (100) having a plurality of first solar cell units (10, 10a, 10b) electrically connected with each other, and a first anode and a first cathode, the first solar panel module further comprising:
a first anode junction box (1512) and a first cathode junction box (1511) disposed along one short edge of the first back surface (102) and electrically connected to a first anode and a first cathode respectively;
a first anode auxiliary junction box (1514) and a first cathode auxiliary junction box (1513) disposed along the other short edge of the first back surface (102) opposite to the one short edge;
a first anode cable (1412) electrically connecting the first anode junction box (1512) and the first anode auxiliary junction box (1514); and
a first cathode cable (1411) electrically connecting the first cathode junction box (1511) and the first cathode auxiliary junction box, (1513)
wherein there are no bypass diodes disposed in the first anode junction box (1512), the first cathode junction box (1511), the first anode auxiliary junction box (1514) and the first cathode auxiliary junction box (1513).

2. The solar panel apparatus of claim 1, wherein the plurality of first solar cell units (10, 10a, 10b) are electrically connected in serial.

3. The solar panel apparatus of claim 1 further comprising:
a first three-way connector (T2) and a second three-way connector (T1);
an anode external connecting cable and a cathode external connecting cable, the anode external connecting cable electrically connecting the first anode junction box (1512) and a first terminal of the first three-way connector (T2), the cathode external connecting cable electrically connecting the first cathode junction box (1511) and a first terminal of the second three-way connector (T1).

4. The solar panel apparatus of claim 3 further comprising:
a bypass diode (BD) electrically coupling a second terminal of the first three-way connector (T2) and a second terminal of the second three-way connector (T1).

5. The solar panel apparatus of claim 2 further comprising:
a first anode internal connecting cable and a first cathode internal connecting cable, the first anode internal connecting cable electrically connecting the first anode auxiliary junction box (1514) and a second anode of a second solar panel module (M2), the first cathode internal connecting cable electrically connecting the first cathode auxiliary junction box (1513) and a second cathode of the second solar panel module (M2).

6. The solar panel apparatus of claim 5 further comprising:
a n^{th} solar panel module (Mn) comprising a n^{th} front surface (101) configured to subject to sun light and a n^{th} back surface (102) configured to be away from sun light, at least one n^{th} solar panel (100) having a plurality of n^{th} solar cell units (10, 10a, 10b) electrically connected with each other, and a n^{th} anode and a n^{th} cathode, the n^{th} solar panel module (Mn) further comprising:
a n^{th} anode junction box (15n2) and a n^{th} cathode junction box (15n1) disposed along one short edge of the n^{th} back surface (102) and electrically connected to a n^{th} anode and a n^{th} cathode respectively;
a n^{th} anode auxiliary junction box (15n4) and a n^{th} cathode auxiliary junction box (15n3) disposed along the other short edge of the n^{th} back surface (102) opposite to the one short edge;
a n^{th} anode cable electrically connecting the n^{th} anode junction box (15n2) and the n^{th} anode auxiliary junction box (15n4); and
a n^{th} cathode cable electrically connecting the n^{th} cathode junction box (15n1) and the n^{th} cathode auxiliary junction box (15n3),
wherein the solar panel apparatus (1000) further comprising:
a n^{th} anode internal connecting cable and a n^{th} cathode internal connecting cable, the n^{th} anode internal connecting cable electrically connecting the n^{th} anode auxiliary junction box (15n4) and a (n+1)^{th} anode of a (n+1)^{th} solar panel module (M(n+1)), the n^{th} cathode internal connecting cable electrically connecting the n^{th} cathode auxiliary junction box (15n3) and a (n+1)^{th} cathode of the (n+1)^{th} solar panel module (M(n+1)),
wherein n is an integer equivalent to or greater than 2.

7. The solar panel apparatus of claim 6 further comprising:
a (n+1)^{th} solar panel module (M(n+1)) comprising a (n+1)^{th} front surface (101) configured to subject to sun light and a (n+1)^{th} back surface (102) configured to be away from sun light, at least one (n+1)^{th} solar panel (100) having a plurality of (n+1)^{th} solar cell units (10, 10a, 10b) electrically connected with each other, and the (n+1)^{th} anode and the (n+1)^{th} cathode, the (n+1)^{th} solar panel module (M(n+1)) further comprising:
a (n+1)^{th} anode junction box (15(n+1)2) and a (n+1)^{th} cathode junction box (15(n+1)1) disposed along one short edge of the (n+1)^{th} back surface (102) and electrically connected to the (n+1)^{th} anode and the (n+1)^{th} cathode respectively.

8. The solar panel apparatus of claim 7, wherein there are no bypass diodes disposed in all junction boxes of the n^{th} and (n+1)^{th} solar panel modules (Mn, M(n+1)).

9. The solar panel apparatus of claim 7, wherein the (n+1)^{th} solar panel module (M(n+1)) comprises no junction boxes other than the (n+1)^{th} anode junction box (15(n+1)2) and the (n+1)^{th} cathode junction box (15(n+1)1).

10. The solar panel apparatus of claim 9, wherein the first solar panel module (M1) through the (n+1)^{th} solar panel module (M(n+1)) are electrically connected in parallel.

## Patentansprüche

1. Ein Solarpanelapparat (1000), bestehend aus:
einem ersten Solarmodul (M1), das aus einer ersten Frontfläche (101), die dem Sonnenlicht ausgesetzt ist, und einer ersten Rückfläche (102), die vom Sonnenlicht abgewendet ist, mindestens einem ersten Solarpanel (100) mit mehreren ersten Solarzelleneinheiten (10, 10a, 10b), die elektrisch miteinander verbunden sind, und einer ersten Anode sowie einer ersten Kathode besteht, wobei das erste Solarmodul weiter aus den folgenden Komponenten besteht:
einer ersten Anoden-Anschlussdose (1512) und einer ersten Kathoden-Anschlussdose (1511), die einer kurzen Kante der ersten Rückfläche (102) entlang angeordnet und elektrisch mit einer ersten Anode bzw. einer ersten Kathode verbunden sind;
einer ersten Anoden-Hilfsanschlussdose (1514) und einer ersten Kathoden-Hilfsanschlussdose (1513), die der anderen kurzen Kante der ersten Rückfläche (102) gegenüber der ersteren kurzen Kante angeordnet sind;
einem ersten Anodenkabel (1412), mit dem die erste Anoden-Anschlussdose (1512) mit der ersten Anoden-Hilfsanschlussdose (1514) verbunden ist; und
einem ersten Kathodenkabel (1411), mit dem die erste Kathoden-Anschlussdose (1511) elektrisch mit der ersten Kathoden-Hilfsanschlussdose, (1513) verbunden ist
wobei in der ersten Anoden-Anschlussdose (1512), der ersten Kathoden-Anschlussdose (1511), der ersten Anoden-Hilfsanschlussdose (1514) und in der ersten Kathoden-Hilfsanschlussdose (1513) keine Bypass-Dioden vorgesehen sind.

2. Der Solarpanelapparat nach Anspruch 1, wobei die mehreren ersten Solarzelleneinheiten (10, 10a, 10b) elektrisch serienverbunden sind.

3. Der Solarpanelapparat nach Anspruch 1, weiter bestehend aus:
einem ersten Dreiweganschluss (T1) und einem zweiten Dreiweganschluss (T2);
einem äußeren Anoden-Verbindungskabel und einem äußeren Kathoden-Verbindungskabel, wobei mit dem äußeren Anoden-Verbindungskabel die erste Anoden-Anschlussdose (1512) elektrisch mit einem ersten Leiteranschluss des ersten Dreiweganschlusses (T1) und mit dem äußeren Kathoden-Verbindungskabel die erste Kathoden-Anschlussdose (1511) elektrisch mit einem ersten Leiteranschluss des zweiten Dreiweganschlusses (T2) verbunden sind.

4. Der Solarpanelapparat nach Anspruch 3, weiter bestehend aus:
einer Bypass-Diode (BD), die elektrisch mit einem zweiten Leiteranschluss des ersten Dreiweganschlusses (T1) und mit einem zweiten Leiteranschluss des zweiten Dreiweganschlusses (T2) verbunden ist.

5. Der Solarpanelapparat nach Anspruch 2, weiter bestehend aus:
einem ersten inneren Anoden-Verbindungskabel und einem ersten inneren Kathoden-Verbindungskabel, wobei mit dem ersten inneren Anoden-Verbindungskabel die erste Anoden-Hilfsanschlussdose (1514) elektrisch mit einer zweiten Anode eines zweiten Solarmoduls (M2) und mit dem ersten inneren Kathoden-Verbindungskabel die erste Kathoden-Hilfsanschlussdose (1513) elektrisch mit einer zweiten Kathode des zweiten Solarmoduls (M2) verbunden werden.

6. Der Solarpanelapparat nach Anspruch 5, weiter bestehend aus:
einem n-ten Solarmodul (Mn), das aus einer n-ten Frontfläche (101), die dem Sonnenlicht ausgesetzt ist, und einer n-ten Rückfläche (102), die vom Sonnenlicht abgewendet ist, mindestens einem n-ten Solarpanel (100) mit mehreren n-ten Solarzelleneinheiten (10, 10a, 10b), die elektrisch miteinander verbunden sind, und einer n-ten Anode sowie einer n-ten Kathode besteht, wobei das n-te Solarmodul (Mn) weiter aus den folgenden Komponenten besteht:
einer n-ten Anoden-Anschlussdose (15n2) und einer n-ten Kathoden-Anschlussdose (15n1), die einer kurzen Kante der n-ten Rückfläche (102) entlang angeordnet und elektrisch mit einer n-ten Anode bzw. einer n-ten Kathode verbunden sind;
einer n-ten Anoden-Hilfsanschlussdose (15n4) und einer n-ten Kathoden-Hilfsanschlussdose (15n3), die der anderen kurzen Kante der n-ten Rückfläche (102) gegenüber der ersteren kurzen Kante angeordnet sind;
einem n-ten Anodenkabel, mit dem die n-te Anoden-Anschlussdose (15n2) mit der n-ten Anoden-Hilfsanschlussdose (15n4) verbunden ist; und
einem n-ten Kathodenkabel, mit dem die n-te Kathoden-Anschlussdose (15n1) mit der n-ten Kathoden-Hilfsanschlussdose (15n3) verbunden wird,
wobei der Solarpanelapparat (1000) weiter aus den folgenden Komponenten besteht:
einem n-ten inneren Anoden-Verbindungskabel und einem n-ten inneren Kathoden-Verbindungskabel, wobei mit dem n-ten inneren Anoden-Verbindungskabel die n-te Anoden-Hilfsanschlussdose (15n4) elektrisch mit einer (n+1)-ten Anode eines (n+1)-ten Solarmoduls (M(n+1)) und mit dem n-ten inneren Kathoden-Verbindungskabel die n-te Kathoden-Hilfsanschlussdose (15n3) elektrisch mit der (n+1)-ten Kathode des (n+1)-ten Solarmoduls (M(n+1)) verbunden sind,
wobei n eine ganze Zahl ist, die gleich wie oder größer als 2 ist.

7. Der Solarpanelapparat nach Anspruch 6, weiter bestehend aus:
einem (n+1)-ten Solarmodul (M(n+1)), das aus einer (n+1)-ten Frontfläche (101), die dem Sonnenlicht ausgesetzt ist, einer (n+1)-ten Rückfläche (102), die vom Sonnenlicht abgewendet ist, mindestens einem (n+1)-ten Solarpanel (100) mit mehreren (n+1)-ten Solarzelleneinheiten (10, 10a, 10b), die elektrisch miteinander verbunden sind, und der (n+1)-ten Anode sowie aus der (n+1)-ten Kathode besteht, wobei das (n+1)-te Solarmodul (M(n+1)) weiter aus den folgenden Komponenten besteht:
einer (n+1)-ten Anoden-Anschlussdose (15(n+1)2) und einer (n+1)-ten Kathoden-Anschlussdose (15(n+1)1), die einer kurzen Kante der (n+1)-ten Rückfläche (102) entlang angeordnet und elektrisch mit der (n+1)-ten Anode bzw. der (n+1)-ten Kathode verbunden sind.

8. Der Solarpanelapparat nach Anspruch 7, wobei in allen Anschlussdosen der n-ten und (n+1)-ten Solarmodule (Mn, M(n+1)) keine Bypass-Dioden vorgesehen sind.

9. Der Solarpanelapparat nach Anspruch 7, wobei das (n+1)-te Solarmodul (M(n+1)) außer der (n+1)-ten Anoden-Anschlussdose (15(n+1)2) und der (n+1)-ten Kathoden-Anschlussdose (15(n+1)1) aus keinen weiteren Anschlussdosen besteht.

10. Der Solarpanelapparat nach Anspruch 9, wobei das erste Solarmodul (M1) über das (n+1)-te Solarmodul (M(n+1)) elektrisch parallelverbunden ist.

## Revendications

1. Appareil de panneaux solaires (1000) **caractérisé par le fait qu'**il comprend :
premier module de panneaux solaires (M1) comprenant une première surface frontale (101) configurée pour être exposée à la lumière solaire et une première surface arrière (102) configurée pour rester éloignée de la lumière solaire, au moins un premier panneau solaire (100) comportant une pluralité de premières unités de cellules solaires (10, 10a, 10b) connectées électriquement entre elles, et une première anode et une première cathode, le premier module de panneaux solaires **caractérisé par le fait qu'**il comprend en outre :
une boîte de jonction de la première anode (1512) et une boîte de jonction de la première cathode (1511) placées le long d'un rebord court de la première surface arrière (102) et connectées électriquement à une première anode et une première cathode respectivement ;
une boîte de jonction auxiliaire de la première anode (1514) et une boîte de jonction auxiliaire de la première cathode (1513) placées le long de l'autre rebord court de la première surface arrière (102) à l'opposé du premier rebord court ;
un câble de la première anode (1412) connectant électriquement la boîte de jonction de la première anode (1512) et la boîte de jonction auxiliaire de la première anode (1514) ; et
un câble de la première cathode (1411) connectant électriquement la boîte de jonction de la première cathode (1511) et la boîte de jonction auxiliaire de la première cathode (1513),
il n'y a pas de diodes de dérivation dans la boîte de jonction de la première anode (1512), la boîte de jonction de la première cathode (1511), la boîte de jonction auxiliaire de la première anode (1514) ni la boîte de jonction auxiliaire de la première cathode (1513).

2. Appareil de panneaux solaires de la revendication 1, **caractérisé par le fait que** la pluralité de premières unités de cellules solaires (10, 10a, 10b) sont connectées électriquement en série.

3. Appareil de panneaux solaires de la revendication 1 **caractérisé par le fait qu'**il comprend en outre :
un premier connecteur à trois voies (T2) et un second connecteur à trois voies (T1) ;
un câble externe de connexion d'anode et un câble externe de connexion de cathode, le câble externe de connexion d'anode connectant électriquement la boîte de jonction de la première anode (1512) et une première borne du premier connecteur à trois voies (T2), le câble externe de connexion de cathode connectant électriquement la boîte de jonction de la première cathode (1511) et une première borne du second connecteur à trois voies (T1).

4. Appareil de panneaux solaires de la revendication 3 **caractérisé par le fait qu'**il comprend en outre :
une diode de dérivation (BD) couplant électriquement une seconde borne du premier connecteur à trois voies (T2) et une seconde borne du second connecteur à trois voies (T1).

5. Appareil de panneaux solaires de la revendication 2 **caractérisé par le fait qu'**il comprend en outre :
un câble interne de connexion de la première anode et un câble interne de connexion de la première cathode, le câble interne de connexion de la première anode connectant électriquement la boîte de jonction auxiliaire de la première anode (1514) et une seconde anode d'un second module de panneaux solaires (M2), le câble interne de connexion de la première cathode connectant électriquement la boîte de jonction auxiliaire de la première cathode (1513) et une seconde cathode du premier module de panneaux solaires (M2).

6. Appareil de panneaux solaires de la revendication 5 **caractérisé par le fait qu'**il comprend en outre :
un n^{ième} module de panneaux solaires (Mn) comprenant une n^{ième} surface frontale (101) configurée pour être exposée à la lumière solaire et une n^{ième} surface arrière (102) configurée pour rester éloignée de la lumière solaire, au moins un n^{ième} panneau solaire (100) comportant une pluralité de n^{ièmes} unités de cellules solaires (10, 10a, 10b) connectées électriquement entre elles, et une n^{ième} anode et une n^{ième} cathode, le n^{ième} module de panneaux solaires (Mn) **caractérisé par le fait qu'**il comprend en outre :
une boîte de jonction d'une n^{ième} anode (15n2) et une boîte de jonction d'une n^{ième} cathode (15n1) placées le long d'un rebord court de la n^{ième} surface arrière (102) et connectées électriquement à une n^{ième} anode et à une n^{ième} cathode respectivement ;
une boîte de jonction auxiliaire d'une n^{ième} anode (15n4) et une boîte de jonction auxiliaire d'une n^{ième} cathode (15n3) placées le long de l'autre rebord court de la n^{ième} surface arrière (102) à l'opposé du premier rebord court ;
un câble d'une n^{ième} anode connectant électriquement la boîte de jonction de la n^{ième} anode (15n2) et la boîte de jonction auxiliaire de la n^{ième} anode (15n4) ; et
un câble d'une n^{ième} cathode connectant électriquement la boîte de jonction de la n^{ième} cathode (15n1) et la boîte de jonction auxiliaire de la n^{ième} cathode (15n3),
l'appareil de panneaux solaires (1000) **caractérisé par le fait qu'**il comprend en outre :
un câble interne de connexion d'une n^{ième} anode et un câble interne de connexion d'une n^{ième} cathode, le câble interne de connexion de la n^{ième} anode connectant électriquement la boîte de jonction auxiliaire de la n^{ième} anode (15n4) et une (n+1)^{ième} anode d'un (n+1)^{ième} module de panneaux solaires (M(n+1)), le câble interne de connexion de la n^{ième} cathode connectant électriquement la boîte de jonction auxiliaire de la n^{ième} cathode (15n3) et une (n+1)^{ième} cathode du (n+1)^{ième} module de panneaux solaires (M(n+1)),
n est un nombre entier équivalent ou supérieur à 2.

7. Appareil de panneaux solaires de la revendication 6 **caractérisé par le fait qu'**il comprend en outre :
un (n+1)^{ième} module de panneaux solaires (M(n+1)) comprenant une (n+1)^{ième} surface frontale (101) configurée pour être exposée à la lumière solaire et une (n+1)^{ième} surface arrière (102) configurée pour rester éloignée de la lumière solaire, au moins un (n+1)^{ième} panneau solaire (100) comportant une pluralité de (n+1)^{ièmes} unités de cellules solaires (10, 10a, 10b) connectées électriquement entre elles, et la (n+1)^{ième} anode et la (n+1)^{ième} cathode, le (n+1)^{ième} module de panneaux solaires (M(n+1)) **caractérisé par le fait qu'**il comprend en outre :
une boîte de jonction d'une (n+1)^{ième} anode (15(n+1)2) et une boîte de jonction d'une (n+1)^{ième} cathode (15(n+1)1) placées le long d'un rebord court de la (n+1)^{ième} surface arrière (102) et connectées électriquement à la (n+1)^{ième} anode et à la (n+1)^{ième} cathode respectivement.

8. Appareil de panneaux solaires de la revendication 7, **caractérisé par le fait qu'**il n'y a pas de diodes de dérivation placées dans toutes les boîtes de jonction du n^{ième} et (n+1)^{ième} modules de panneaux solaires (Mn, M(n+1)).

9. Appareil de panneaux solaires de la revendication 7, **caractérisé par le fait que** le (n+1)^{ième} module de panneaux solaires (M(n+1)) ne comprend pas de boîtes de jonction autres que la boîte de jonction de la (n+1)^{ième} anode (15(n+1)2) et la boîte de jonction de la (n+1)^{ième} cathode (15(n+1)1).

10. Appareil de panneaux solaires de la revendication 9, **caractérisé par le fait que** le premier module de panneaux solaires (M1) et le (n+1)^{ième} module de panneaux solaires (M(n+1)) sont connectés électriquement en parallèle.
